Europäisches Patentamt

European Patent Office

Office européen des brevets

(19)

(11) Publication number: **0 183 417**

**A2**

(12)

# EUROPEAN PATENT APPLICATION

(21) Application number: **85308146.1**

(22) Date of filing: **08.11.85**

(51) Int. Cl.⁴: **G 02 B 1/10**
**G 02 B 21/00, G 01 R 31/28**

(30) Priority: **30.11.84 DE 3443729**

(43) Date of publication of application:
**04.06.86 Bulletin 86/23**

(84) Designated Contracting States:
**AT FR GB**

(71) Applicant: **C. Reichert Optische Werke AG**
**P.O. Box 95 Hernalser Hauptstrasse 219**
**A-1170 Vienna(AT)**

(72) Inventor: **Lihl, Reinhard**
**Belghofergasse 29**
**A-1120 Vienna(AT)**

(72) Inventor: **Nyman, Georg**
**Franz Grasslergasse 40**
**A-1230 Vienna(AT)**

(74) Representative: **Coxon, Philip et al,**
**Eric Potter & Clarkson 14 Oxford Street**
**Nottingham NG1 5BP(GB)**

(54) Optical element with antireflection coating, for use in microscopes.

(57) An optical element having an antireflection coating, for use in microscopes, particularly microscopes intended for use with infrared radiation. The optical element is provided with at least one surface, and at least one antireflection coating is provided on said surface. The minimum reflection of the antireflection coating is at a wavelength (λ) in the range 800–2000nm.

# OPTICAL ELEMENT WITH ANTIREFLECTION COATING, FOR USE IN MICROSCOPES

This invention relates to optical elements, having an antireflection coating, for use in microscopes, particularly microscopes intended for use with infrared radiation.

Microscopes used with infrared radiation are, for example, employed in the semiconductor industry in the examination of silicon wafers, the basic silicon material being transparent to infrared. In these appliances an image is picked up by means of special infrared-sensitive television tubes and is displayed on a monitor. All these systems use optical components such as lenses and prisms, and in particular use objective lenses which have been given an optimal antireflection coating for visible light.

The antireflection coating for visible light has the characteristic that in the neighbouring infrared and ultraviolet regions it causes particularly high indices of reflection; these are far above those for uncoated glass. This gives rise to contrast losses in transmitting optics caused by reflection backwards and forwards at the optical surfaces. It also gives rise to losses in brightness, since the light which has been reflected once is lost for the second image and at most reappears in the picture as stray light after a second reflection. The problem is particularly acute for incident light objective lenses which are illuminated by a vertical illuminator, for example a mirror, and in which the direct reflection even after a single reflection is superimposed on the picture as stray light.

It is an object of the present invention to provide an optical element of a microscope in which these problems can be avoided. It is further object to provide a microscope which is specially suited to infrared studies.

According to one aspect of the invention there is provided an optical element for use in a microscope, said optical element having at least one surface with at least one antireflection coating on said at least one surface, the minimum reflection of the antireflection coating being at a wavelength ($\lambda$) in the range 800 - 2000 nm.

Advantageously the minimum reflection is at a wavelength of approximately 1400 nm.

In one embodiment a single layer coating is provided, and this is especially suitable when the optical element has a refractive index (n) above about 1.6. In this embodiment the coating is preferably $MgF_2$, and preferably has a thickness of about $\lambda/4$.

In another embodiment the coating comprises a plurality of layers. In this embodiment it is preferred that two layers are used when the refractive index of the optical element is above about 1.6, and that three layers are used when the refractive index of the optical element is below about 1.6.

When two layers are employed the coating desirably comprises a first layer remoted from the optical element and a second layer adjacent the optical element, the first layer having a refractive index (n) between about 1.35 and 1.63 and having a thickness of approximately $\lambda/4$, and the second layer having a refractive index (n) of between about 2 and 2.3 and having a thickness of approximately $\lambda/2$.

When three layers are employed the coating preferably comprises a first layer remote from the optical element, a second layer adjacent the optical element and an intermediate layer, the first layer having a refractive index (n) between about 1.35 and 1.63 and having a thickness of approximately $\lambda/4$, the intermediate layer having a refractive index (n) between about 2 and 2.3 and having a thickness of approximately $\lambda/2$, and the second layer having a refractive index (n) between about 1.56 and 1.72 and having a thickness of approximately $\lambda/4$.

In both the two and three layer constructions the first layer may be selected from the group $MgF_2$ (n = 1.385), $SiO_2$ (n = 1.46), $ThF_4$ (n = 1.5), $LaF_2$ (n = 1.56), $Na_3(AlF_4)$ (n = 1.35), $Al_2O_3$ (n = 1.62) and $CeF_3$ (n = 1.615).

In the two layer construction the second layer, and in the three layer construction the intermediate layer, may be selected from the group $CeO_2$ (n = 2.30 - 2.00), $ZrO_2$ (n = 2.10 - 2.00), $TiO_2$ (n = 2.30 - 2.00), $Ta_2O_5$ (n = 2.30 - 2.00), $ZnS$ (n = 2.30 - 2.20) and $ThO_2$ (n = 2.20 - 2.00).

In the three layer construction the second layer may be selected from the group $Al_2O_3$ (n = 1.65 - 1.56), $MgO$ (n = 1.72), $CeF_3$ (n = 1.62), $LaF_3$ (n = 1.59), $NdF_3$ (n = 1.60), $BeO$ (n = 1.60), $ThOH_2$ (n = 1.70), $InO_2$ (n = 1.8 - 1.9) and a mixture of $MgO$ and $Al_2O_3$ (n = 1.72 - 1.65).

It is preferred that the entire surface of the optical element is coated with the antireflection coating. Typically the optical element is a glass optical element.

According to another aspect of the invention there is provided a microscope having imaging optics comprising a plurality of optical elements, at least one of said optical elements having at least one surface with at least one antireflection coating on said at least one surface, the minimum reflection of the antireflection coating being at a wavelength ( $\lambda$ ) in the range 800 - 2000 nm.

Advantageously the minimum reflection is at a wavelength of approximately 1400 nm.

The coating may be a single layer coating, or may comprise a plurality of layers as described in the above embodiments.

The antireflection coating may be provided on the objective lenses of the microscope. In this manner, by coating the incident light objective lenses the particularly strong reflections can be eliminated.

The antireflection coating may be provided on the rest of the imaging optics in the microscope. In addition, the antireflection coating may be provided on the illuminating optics.

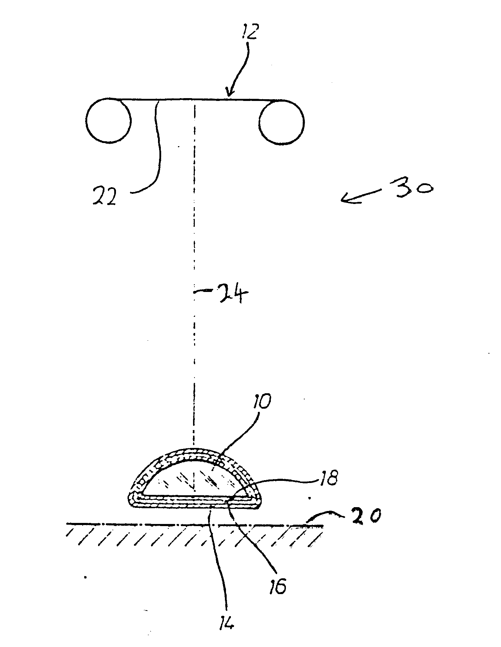

Reference is now made to the accompanying drawing which is a schematic view of a microscope having an optical element according to the invention.

In the drawing a microscope 30 comprises an objective lens 10 which projects an image of an object (not shown) from an object plane 20 to a film plane 22 of a camera 12. The camera 12 may be, for example, a film camera or a television camera.

The image of the object is projected along a beam path 24 extending from the lens 10 to the film plane 22.

The objective lens 10 has an antireflection coating comprising a first layer 14 remote from the objective lens 10, a second layer 18 adjacent the objective lens 10, and an intermediate layer 16 arranged between the first and second layers.

The refractive indices and materials of construction of the first, second and intermediate layers correspond to the refractive indices and materials of construction of the first, second and intermediate layers described above.

CLAIMS

1.   An optical element for use in a microscope, characterised in that said optical element has at least one surface with at least one antireflection coating on said at least one surface, the minimum reflection of the antireflection coating being at a wavelength ( $\lambda$ ) in the range 800 - 2000 nm.

2.   A microscope having imaging optics characterised by a plurality of optical elements, at least one of said optical elements having at least one surface with at least one antireflection coating on said at least one surface, the minimum reflection of the antireflection coating being at a wavelength ( $\lambda$ ) in the range 800 - 2000 nm.

3.   An optical element according to Claim 1 or 2 characterised in that the minimum reflection is at a wavelength of approximately 1400 nm.

4.   An optical element according to Claim 1, 2 or 3 characterised in that the coating is a single layer coating of magnesium fluoride having a thickness of approximately $\lambda/4$.

5.   An optical element according to Claim 1, 2 or 3 characterised in that the antireflection coating comprises a plurality of layers.

6.   An optical element according to Claim 5 characterised in that the material of the optical element has a refractive index (n) of above 1.6 and the coating comprises:

a first layer remote from the optical element and a second layer adjacent the optical element, the first layer having a refractive index (n) between 1.35 and 1.63 and having a thickness of approximately $\lambda/4$,

and the second layer having a refractive index (n) of between 2 and 2.3 and having a thickness of approximately $\lambda/2$.

7. An optical element according to Claim 6 characterised in that the second layer is selected from the group $CeO_2$ (n = 2.30 - 2.00), $ZrO_2$ (n = 2.10 - 2.00), $TiO_2$ (n = 2.30 - 2.00), $Ta_2O_5$ (n = 2.30 - 2.00), ZnS (n = 2.30 - 2.20) and $ThO_2$ (n = 2.20 - 2.00).

8. An optical element according to Claim 5 characterised in that the material of the optical element has a refractive index (n) of below 1.6 and the coating comprises:

a first layer remote from the optical element, a second layer adjacent the optical element and an intermediate layer,

the first layer having a refractive index (n) between 1.35 and 1.63 and having a thickness of approximately $\lambda/4$,

the intermediate layer having a refractive index (n) between 2 and 2.3 and a thickness of approximately $\lambda/2$, and

the second layer having a refractive index (n) between 1.56 and 1.72 and a thickness of approximately $\lambda/4$.

9. An optical element according to Claim 6 or 8 characterised in that the first layer is selected from the group $MgF_2$ (n = 1.385), $SiO_2$ (n = 1.46), $ThF_4$ (n = 1.5), $LaF_2$ (n = 1.56), $Na_3(AlF_4)$ (n = 1.35), $Al_2O_3$ (n = 1.62) and $CeF_3$ (n = 1.615).

10. An optical element according to Claim 8 characterised in that the intermediate layer is selected from the group $CeO_2$ (n = 2.30 - 2.00), $ZrO_2$ (n = 2.10 - 2.00), $TiO_2$ (n = 2.30 - 2.00), $Ta_2O_5$ (n = 2.30 - 2.00), ZnS (n = 2.30 - 2.20) and $ThO_2$ (n = 2.20 - 2.00).

11. An optical element according to Claim 8 characterised in that the second layer is selected from the group $Al_2O_3$ (n = 1.65 - 1.56), MgO (n = 1.72), $CeF_3$ (n = 1.62), $LaF_3$ (n = 1.59), $NdF_3$ (n = 1.60), BeO (n = 1.60), $ThOH_2$ (n = 1.70), $InO_2$ (n = 1.8 - 1.9) and a mixture of MgO and $Al_2O_3$ (n = 1.72 - 1.65).